# EUROPÄISCHE PATENTSCHRIFT

(11) **EP 2 011 142 B1**
(45) Veröffentlichungstag und Bekanntmachung des Hinweises auf die Patenterteilung: **15.07.2020**
(21) Anmeldenummer: 07722283.4
(22) Anmeldetag: 20.04.2007
(51) Int. Cl.: H01L 21/762, H01L 31/18, H01L 33/00

(54) **VERFAHREN ZUR HERSTELLUNG EINES VERBUNDSUBSTRATS**
METHOD FOR THE PRODUCTION OF A COMPOSITE SUBSTRATE
PROCÉDÉ DE FABRICATION D'UN SUBSTRAT COMPOSITE

(30) Priorität: 25.04.2006 DE 102006019110
(43) Veröffentlichungstag der Anmeldung: 07.01.2009
(73) Patentinhaber: OSRAM Opto Semiconductors GmbH, 93055 Regensburg (DE)
(72) Erfinder: HÄRLE, Volker, 93164 Laaber (DE); STRAUSS, Uwe, 93077 Bad Abbach (DE); BRÜDERL, Georg, 93133 Burglengenfeld (DE); EICHLER, Christoph, 93105 Tegernheim (DE); AVRAMESCU, Adrian, 93049 Regensburg (DE)
(74) Vertreter: Epping - Hermann - Fischer
(86) Internationale Anmeldenummer: PCT/DE2007/000725
(87) Internationale Veröffentlichungsnummer: WO 2007/121735

(56) Entgegenhaltungen:
- EP-A1- 1 811 543
- WO-A-02/43112
- WO-A-03/105219
- WO-A2-2007/117775
- FR-A- 2 787 919
- US-A1- 2002 089 016
- US-A1- 2005 196 937
- US-A1- 2005 269 671
- US-B1- 6 251 754

## Beschreibung

Die Erfindung betrifft ein Verbundsubstrat sowie ein Verfahren zur Herstellung hierzu.

Für zahlreiche optoelektronische Bauteile, insbesondere Halbleiterchips, zum Beispiel Halbleiterchips auf III-V-Halbleitermaterialbasis, etwa auf GaN-Basis, sind hochwertige Substrate notwendig. Da diese Substrate zum Teil sehr kostenintensiv sind, ist es zweckmäßig, mehrmals eine dünne Schicht dieses ersten, hochwertigen (Mutter-) Substrats auf kostengünstigere Sekundär-Substrate zu übertragen. Ein mögliches Verfahren hierzu ist die Erzeugung einer Trennzone, zum Beispiel einer lateralen Bruchkeimzone, beispielsweise durch Implantation in das Muttersubstrat, Waferbonden mit einem Sekundärsubstrat und Abspalten des Muttersubstrats an der Trenn- beziehungsweise Bruchkeimzone, wobei die oberste Nutzschicht des Muttersubstrats fest mit dem Sekundärsubstrat verbunden bleibt. Dies ist beispielsweise in den Druckschriften WO 02/43112 A2, US 2005/0196937 A1 und US 6,251,754 B1 beschrieben.

Das oben beschriebene Verfahren zeigt aber in der praktischen Umsetzung Einschränkungen. So stellen unterschiedliche thermische Ausdehnung von Muttersubstrat und Sekundärsubstrat sowie Scheibenkrümmungen (Bow) und Aufbiegungen (Warp) hohe Anforderungen an die Haftkraft beim Verbindungsprozess.

Eine Aufgabe der Erfindung ist es, ein verbessertes Herstellungsverfahren für ein Verbundsubstrat anzugeben. Weiterhin ist es eine Aufgabe, ein zugehöriges Herstellungsverfahren für einen Halbleiterchip anzugeben. Diese Aufgaben werden mittels der Gegenstände des unabhängigen Patentanspruchs 1 gelöst. Vorteilhafte Ausgestaltungen und Weiterbildungen sind Gegenstand der abhängigen Patentansprüche.

Es wird ein Verfahren angegeben, bei dem die Bondstabilität derart erhöht wird, dass die Anforderungen an das Muttersubstrat bezüglich Scheibenrauhigkeit beziehungsweise Planarität, aber auch bezüglich Scheibenkrümmung (Bow) und Welligkeit reduziert werden können. Insbesondere wird die Bondstabilität bei großen Oberflächenrauhigkeiten, zum Beispiel größer 0,1 nm, etwa 0,5 nm bis 10 nm, verbessert.

Bei einem erfindungsgemäßen Verfahren zur Herstellung eines Verbundsubstrats wird ein Nutzsubstrat bereitgestellt. Auf das Nutzsubstrat wird eine Planarisierungsschicht aufgebracht. Das Nutzsubstrat wird auf einem Substratkörper für das Verbundsubstrat befestigt, wobei die Planarisierungsschicht dem Substratkörper zugewandt ist. Nachfolgend wird das Nutzsubstrat abgetrennt, wobei eine Nutzschicht des Nutzsubstrats für das Verbundsubstrat auf dem Substratkörper verbleibt.

Die Nutzschicht ist insbesondere für die Abscheidung einer Halbleiterschicht oder einer Halbleiterschichtenfolge für ein, vorzugsweise elektronisches oder optoelektronisches, Halbleiterbauelement vorgesehen. Der vom Verbundsubstrat abgetrennte Teil des Nutzsubstrats kann wiederverwendet werden. So kann ein kostenintensives Nutzsubstrat, etwa ein Substrat, das GaN enthält oder aus GaN besteht, für die Herstellung mehrerer Verbundsubstrate verwendet werden. Das Verbundsubstrat kann sich daher durch vergleichsweise niedrige Kosten bei gleichzeitig hoher Kristallqualität der Nutzschicht auszeichnen.

Für den Substratkörper wird bevorzugt ein Material gewählt, das hinsichtlich seines thermischen Expansionskoeffizienten an das Nutzsubstrat angepasst ist. Eine mechanisch stabile Verbindung zwischen dem Substratkörper und dem Nutzsubstrat, die insbesondere auch bei starken Temperaturschwankungen standhält, kann dadurch vereinfacht werden.

Der Substratkörper kann beispielsweise Saphir, Silizium, SiC, GaAs oder GaN enthalten oder aus einem solchen Material bestehen.

Zur Verbesserung des Verfahrens für die Übertragung von Kristallschichten auf ein Sekundär-Substrat, zum Beispiel mittels lateraler Bruchkeimbildung und Scheibenbonden, kann ein Zwischen-Prozess oder eine Mehrzahl von Zwischen-Prozessen eingefügt werden. Durch einen solchen Zwischen-Prozess beziehungsweise durch solche Zwischen-Prozesse wird die Anwendbarkeit des Verfahrens mit Vorteil erweitert. Ein derartiger Zwischen-Prozess ist beispielsweise das Aufbringen der Planarisierungsschicht auf dem Nutzsubstrat. Die Planarisierungsschicht wird auch als Glättungsschicht bezeichnet.

Die Planarisierungsschicht kann auch zwei oder mehr Teilschichten umfassen.

Die Planarisierungsschicht oder zumindest eine Teilschicht der Planarisierungsschicht kann beispielsweise mittels Aufschleuderns oder mittels eines PVD(physical vapor deposition)-Verfahrens wie Sputterns, zum Beispiel Silizium-Sputterns, vorzugsweise mit nachfolgendem Polieren, hergestellt werden. Auch ein CVD(chemical vapor deposition)-Verfahren kann für die Herstellung eingesetzt werden.

Die Planarisierungsschicht kann dielektrisch sein. Besonders bevorzugt ist die mit einem der genannten Verfahren hergestellte Planarisierungsschicht beziehungsweise Teilschicht der Planarisierungsschicht dielektrisch.

Weiterhin ist diese Planarisierungsschicht beziehungsweise Teilschicht der Planarisierungsschicht bevorzugt derart ausgebildet, dass sie in einem nachfolgenden, vorzugsweise mechanischen, Schritt, vereinfacht geglättet werden kann. Besonders bevorzugt enthält die Planarisierungsschicht ein Siliziumnitrid, wie SiN, ein Siliziumoxinitrid, wie SiON, ein transparentes leitfähiges Oxid (transparent conductive oxide, TCO) wie ITO, ZnO, SnO oder SnO₂, oder ein Siliziumoxid, wie SiO₂.

Die resultierende Rauhigkeit ist kleiner oder gleich 1 nm. Unter der Rauhigkeit wird im Zweifel die quadratische Rauhigkeit, die auch als rms-Rauhigkeit (englisch rms*roughness* = *root-mean-squared roughness)* bezeichnet wird, verstanden. Beispielsweise kann die rms-Rauhigkeit durch ein Rasterkraftmikroskopie (atomic force microscopy, AFM)-Verfahren ermittelt werden.

Ergänzend wird das Muttersubstrat epitaktisch geglättet, nämlich mit Prozessparametern, die laterales Wachstum begünstigen, zum Beispiel GaN-MOVPE bei relativ hohen Temperaturen, beispielsweise oberhalb 1000°C. Die Planarisierungsschicht oder zumindest eine Teilschicht der Planarisierungsschicht wird also mittels eines Epitaxie-Verfahrens, beispielsweise MOVPE oder MBE, abgeschieden.

Die Planarisierungsschicht ist zum Einebnen der Oberfläche des Nutzsubstrats (Muttersubstrats) ausgebildet. Insbesondere kann die Rauhigkeit der der Nutzschicht beziehungsweise dem Nutzsubstrat abgewandten Oberfläche der Planarisierungsschicht gegenüber der der Planarisierungsschicht zugewandten Oberfläche der Nutzschicht beziehungsweise des Nutzsubstrats verringert sein. Mittels der Planarisierungsschicht kann also die dem Substratkörper zur Befestigung zugewandte Oberfläche des Verbunds aus Planarisierungsschicht und Nutzsubstrat eine geringere Rauhigkeit aufweisen. Durch die Planarisierungsschicht kann so die Befestigung des Nutzsubstrats an dem Substratträger vereinfacht werden.

Bevorzugt wird das Nutzsubstrat auf den Substratkörper, insbesondere mittels direkten Bondens, gebondet.
Zwischen dem Substratkörper und dem Nutzsubstrat, insbesondere zwischen dem Substratkörper und der Planarisierungsschicht, wird also eine Bondverbindung ausgebildet.

Im Unterschied zum eutektischen Bonden werden die Verbindungspartner beim direkten Bonden aufgrund atomarer Kräfte zusammengehalten. Für die Herstellung der Bondverbindung ist beim direkten Bonden also das Ausbilden einer metallischen Legierung nicht erforderlich.

Aufgrund der Planarisierungsschicht ist das direkte Bonden zur Befestigung des Nutzsubstrats an dem Substratkörper mit Vorteil auch auf ein Nutzsubstrat anwendbar, dessen Oberfläche ohne eine solche Planarisierungsschicht für ein zuverlässiges Ausbilden einer direkten Bondverbindung zu rau und/oder zu uneben wäre.

In einer weiteren bevorzugten Ausgestaltung wird das Nutzsubstrat vor dem Befestigen an dem Substratkörper geglättet, beispielsweise mechanisch und/oder chemisch. Insbesondere kann das Nutzsubstrat durch Polieren, Schleifen, Läppen oder Ätzen geglättet werden.

Weiterhin wird das Nutzsubstrat bevorzugt vor dem Aufbringen der Planarisierungsschicht geglättet.

In einer weiteren bevorzugten Ausgestaltung wird eine Bondhilfsschicht aufgebracht. Die Bondhilfsschicht ist bevorzugt eine Oxidschicht und kann beispielsweise ein Siliziumoxid, wie SiO₂, ein Siliziumoxinitrid, wie SiON, oder ein TCO-Material wie ITO (Indiumzinnoxid), ZnO, SnO oder SnO₂, enthalten oder aus einem solchen Material bestehen. Alternativ oder ergänzend kann die Bondhilfsschicht ein Siliziumnitrid, wie SiN, enthalten oder aus einem solchen Material bestehen. Mittels der Bondhilfsschicht kann eine mechanisch stabile Befestigung des Nutzsubstrats an dem Substratkörper vereinfacht hergestellt werden.

Die Deposition der Bondhilfsschicht erfolgt bevorzugt bei hohen Temperaturen, zum Beispiel > 300°C. Bei hohen Temperaturen können vereinfacht Schichten mit hoher Dichte abgeschieden werden. Dadurch kann das Ausbilden einer BondVerbindung durch die Bondhilfsschicht weitergehend verbessert werden.

Die Bondhilfsschicht ist zwischen dem Substratkörper und der Planarisierungsschicht angeordnet. Die Bondhilfsschicht ist also zusätzlich zur Planarisierungsschicht ausgebildet.

In einer weiteren Ausführungsvariante wird eine weitere Bondhilfsschicht auf den Substratkörper aufgebracht.

Durch die Bondhilfsschicht und gegebenfalls durch die weitere Bondhilfsschicht kann eine mechanisch stabile Verbindung zwischen dem Substratkörper und dem Nutzsubstrat vereinfacht hergestellt werden.

In einer bevorzugten Ausgestaltung wird im Nutzsubstrat eine Trennzone, die auch als Trennschicht bezeichnet wird, ausgebildet. Die Trennzone verläuft bevorzugt in lateraler Richtung, das heißt entlang einer Haupterstreckungsrichtung des Nutzsubstrats.

Das Abtrennen des Nutzsubstrats erfolgt vorzugsweise entlang dieser Trennzone. Mittels der Trennzone kann also eingestellt werden, an welcher Stelle die Nutzschicht von dem Nutzsubstrat abgetrennt wird.

Die Trennzone ist vorzugsweise derart ausgebildet, dass ein gezieltes Abtrennen des Nutzsubstrats auf einfache und zuverlässige Weise hergestellt werden kann.

Bevorzugt wird das Abtrennen thermisch, etwa mittels Temperns, mechanisch oder mittels Strahlung, etwa Laserstrahlung, induziert.

Die Herstellung der Trennzone kann beispielsweise mittels Implantation eines Stoffs zur Bruchkeimbildung, etwa mittels Atomen oder Ionen wie H+, HH+ oder Bor, erfolgen.

Die Trennzone kann vor, nach oder während der Befestigung des Nutzsubstrats auf dem Substratkörper ausgebildet werden.

In einer bevorzugten Weiterbildung wird die Trennzone erst nach dem Aufbringen der Planarisierungsschicht ausgebildet. Hierfür wird beispielsweise der Stoff für die Bruchkeimbildung erst nach der Planarisierung implantiert, wobei die Implantation bevorzugt durch die Planarisierungsschicht hindurch erfolgt. Auf diese Weise kann mit Vorteil eine besonders ebene Trennzone ausgebildet werden.

In einer weiteren bevorzugten Ausgestaltung werden vor der Befestigung des Nutzsubstrats auf dem Substratkörper Mikrotrennkeime, vorzugsweise entlang der Trennzone, ausgebildet. Diese Mikrotrennkeime können beispielsweise Mikrorisse sein, die zwischen der Nutzschicht und dem verbleibenden Teil des Nutzsubstrats ausgebildet werden. Diese Mikrotrennkeime fördern ein späteres Abtrennen des Nutzsubstrats, insbesondere entlang der Trennzone. Die Mikrotrennkeime sind aber vorzugsweise derart ausgeführt, dass vor dem späteren Abtrennen des Nutzsubstrats noch eine ausreichend mechanisch stabile Verbindung zwischen der Nutzschicht und dem verbleibenden Teil des Nutzsubstrats bestehen bleibt.

Bevorzugt wird ein Muttersubstrat mit leichter Off-Orientierung verwendet. Bei einem solchen Nutzsubstrat ist die Oberfläche des Nutzsubstrats gegenüber einer Ebene, die durch Hauptkristallrichtungen definiert ist, verkippt. Derartige Substrate können sich durch eine glattere Oberfläche auszeichnen.

In einer bevorzugten Weiterbildung wird eine dem Substratkörper abgewandte Oberfläche der Nutzschicht für die Abscheidung einer Halbleiterschichtenfolge auf dieser Oberfläche optimiert. Dies kann mechanisch oder chemisch, insbesondere mittels Ätzens, erfolgen. Rauhigkeiten oder Unebenheiten, die beim Abtrennen des Nutzsubstrats entlang der Trennzone auftreten können, können so mit Vorteil vermindert werden.

Bei einem fertiggestellten Verbundsubstrat ist die Nutzschicht auf dem Substratkörper befestigt, wobei zwischen der Nutzschicht und dem Substratkörper vorzugsweise eine Planarisierungsschicht angeordnet ist.

Das Verbundsubstrat ist vorzugsweise für die Abscheidung einer Halbleiterschicht oder einer Halbleiterschichtenfolge auf der Nutzschicht vorgesehen. Besonders bevorzugt ist das Verbundsubstrat für die Abscheidung einer Halbleiterschicht oder Halbleiterschichtenfolge vorgesehen, die auf einem Nitrid-Verbindungshalbleiter basiert.

"Auf Nitrid-Verbindungshalbleitern basierend" bedeutet im vorliegenden Zusammenhang, dass die aktive EpitaxieSchichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Aufgrund der hohen Kristallqualität der Nutzschicht des Verbundsubstrats können elektronische oder optoelektronische Halbleiterchips mit hoher Qualität hergestellt werden.

Bei einem elektronischen Halbleiterchip ist bevorzugt eine Halbleiterschicht oder eine Halbleiterschichtenfolge für eine elektronisches Bauteil oder für eine elektronische Schaltung auf dem Verbundsubstrat angeordnet.

Ein optoelektronischer Halbleiterchip umfasst bevorzugt eine auf dem Verbundsubstrat angeordnete Halbleiterschichtenfolge mit einen aktiven Bereich, der zur Strahlungserzeugung und/oder zum Strahlungsempfang geeignet ist.

Insbesondere eignet sich das Verbundsubstrat besonders zum Herstellen von hocheffizienten Dünnfilmchips. Ein Dünnfilmchip umfasst einen Dünnfilm-Halbleiterkörper mit einer Halbleiterschichtenfolge, die einen zur Strahlungserzeugung und/oder zum Strahlungsempfang geeigneten aktiven Bereich umfassen kann. Für die Ausbildung eines Dünnfilm-Halbleiterkörpers ist ein Substrat, auf dem die Halbleiterschichtenfolge hergestellt ist, gedünnt, bereichsweise oder vollständig von der Halbleiterschichtenfolge entfernt. Zur mechanischen Stabilisierung kann der Dünnfilm-Halbleiterkörper auf einem Träger, den der Dünnfilmchip umfasst, angeordnet und insbesondere befestigt sein. Dieser Träger ist demnach vom Herstellungssubstrat verschieden. Als Herstellungssubstrat insbesondere für ein epitaktisches Aufwachsen der Halbleiterschichtenfolge ist ein oben und im folgenden näher beschriebenes Verbundsubstrat besonders geeignet.

Ein Dünnfilm-Leuchtdioden-Chip kann sich weiterhin durch folgende charakteristische Merkmale auszeichnen:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20pm oder weniger, insbesondere im Bereich von 10 µm auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich von daher besonders gut für die Anwendung in einem Scheinwerfer.

Bei einem Verfahren zur Herstellung eines optoelektronischen Halbleiterchips wird zunächst ein Verbundsubstrat mit einem Substratkörper und einer auf dem Substratkörper angeordneten Nutzschicht bereitgestellt. Auf der Nutzschicht wird eine Halbleiterschichtenfolge mit einem zur Strahlungserzeugung und/oder zum Strahlungsempfang vorgesehenen aktiven Bereich für den optoelektronischen Halbleiterchip abgeschieden, insbesondere aufgewachsen.

Die Abscheidung der Halbleiterschichtenfolge erfolgt demnach auf der Nutzschicht des Verbundsubstrats, wobei sich die Nutzschicht durch eine hohe Kristallqualität auszeichnen kann. Eine Abscheidung auf einem homogenen Substrat wäre demgegenüber bei vergleichbarer Kristallqualität erheblich kostenintensiver.

In einer bevorzugten Weiterbildung wird das Verbundsubstrat gedünnt, bereichsweise oder vollständig entfernt. Der optoelektronische Halbleiterchip kann also als ein Dünnfilm-Halbleiterchip ausgebildet werden, bei dem das Verbundsubstrat als ein Herstellungssubstrat für die Halbleiterschichtenfolge verwendet wird. Mit Vorteil kann so ein hocheffizienter Dünnfilm-Halbleiterchip besonders kostengünstig gefertigt werden.

In einer bevorzugten Weiterbildung wird die Halbleiterschichtenfolge auf einem von dem Verbundsubstrat verschiedenen Träger befestigt.

Weiterhin weist das Verbundsubstrat vorzugsweise eine direkte Bondverbindung auf.

Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.

Es zeigen:
die Figuren 1A bis 1C ein erstes Ausführungsbeispiel für ein erfindungsgemäßes Herstellungsverfahrens für ein Verbundsubstrat anhand der schematisch in Schnittansicht dargestellten Zwischenschritte,
die Figuren 2A bis 2C ein zweites Ausführungsbeispiel für ein erfindungsgemäßes Herstellungsverfahrens für ein Verbundsubstrat anhand der schematisch in Schnittansicht dargestellten Zwischenschritte,
die Figuren 3A bis 3C ein drittes Ausführungsbeispiel für ein erfindungsgemäßes Herstellungsverfahrens für ein Verbundsubstrat anhand der schematisch in Schnittansicht dargestellten Zwischenschritte,
die Figuren 4A bis 4C ein Ausführungsbeispiel für ein Herstellungsverfahren für einen Halbleiterchip anhand der schematisch in Schnittansicht dargestellten Zwischenschritte, und
Figur 5 ein Beispiel für einen Halbleiterchip mit einem erfindungsgemäß hergestellten Verbundsubstrat.

Gleiche, gleichartige und gleich wirkende Elemente sind in den Figuren mit gleichen Bezugszeichen versehen.

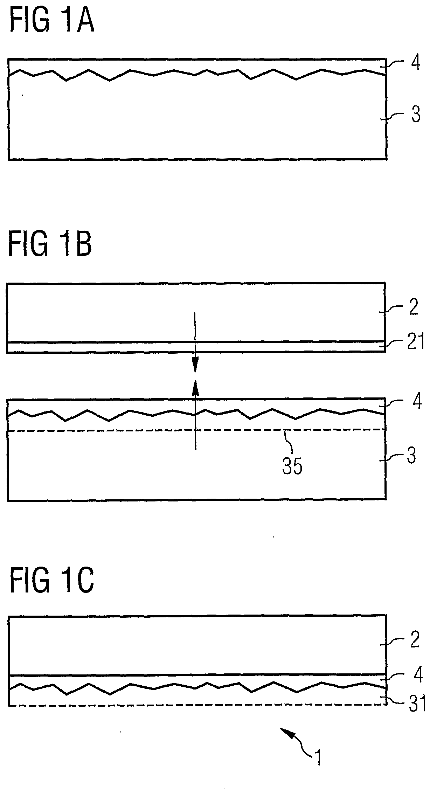

Die Figuren 1A bis 1C zeigen ein erstes Ausführungsbeispiel eines erfindungsgemäßen Verfahrens zur Herstellung eines Verbundsubstrats anhand der schematisch in Schnittansicht dargestellten Zwischenschritte.

Ein Nutzsubstrat (Muttersubstrat) 3 wird zunächst geglättet. Dies ist in Figur 1A schematisch gezeigt. Das Glätten erfolgt mittels einer Planarisierungsschicht 4. Diese Planarisierungsschicht (Glättungsschicht) wird mittels epitaktischen Überwachsens, etwa mittels MOVPE oder MBE hergestellt. Insbesondere kann die Planarisierungsschicht einen III-V-Verbindungshalbleiter, etwa einen Nitrid-Verbindungshalbleiter, enthalten. Beispielsweise kann die Planarisierungsschicht durch MOVPE-GaN-Wachstum auf einem Gaface GaN-Muttersubstrat abgeschieden werden. Die Wachstumstemperatur wird derart eingestellt, dass laterales Wachstum gefördert wird. Beispielsweise kann die Wachstumstemperatur beim Wachstum von GaN 1000-1100° C betragen. Diese Wachstumstemperatur kann beispielsweise mittels eines Pyrometers gemessen werden.

Zusätzlich kann die Planarisierungsschicht 4 mittels Aufschleuderns, zum Beispiel Spin-on-Glas, mittels Aufdampfens oder Sputterns hergestellt werden. Beispielsweise kann die Planarisierungsschicht SiO₂, Al₂O₃, Si₃N₄, oder Si enthalten oder aus einem solchen Material bestehen.

Nachfolgend wird die Planarisierungsschicht 4 chemisch oder mechanisch, zum Beispiel durch Läppen und/oder Polieren weitergehend geglättet.

Ergänzend kann das Nutzsubstrat 3 mittels zum Beispiel Schleifens, Läppens, Polierens und/oder Ätzens geglättet werden.

Die dem Nutzsubstrat 3 abgewandte Oberfläche der Planarisierungsschicht 4 weist eine Rauhigkeit von höchstens 1 nm auf.

In einem nachfolgenden Schritt kann optional eine Oxid-Schicht auf die Oberfläche der Planarisierungsschicht 4 aufgebracht oder die Oberfläche der Planarisierungsschicht 4 oxidiert werden. Die Oxid-Schicht beziehungsweise die oxidierte Planarisierungsschicht kann als Bondhilfsschicht dienen. Eine mechanisch stabile Befestigung des Nutzsubstrats an dem Substratkörper kann dadurch vereinfacht erreicht werden.

Wie in Figur 1B schematisch gezeigt, kann nach der Planarisierung, also insbesondere nach dem Aufbringen der Planarisierungsschicht 4, eine Implantation eines Stoffes zur Erzeugung einer Trennzone 35 (Trennschicht oder auch Bruchkeimschicht) erfolgen. Beispielsweise können Atome oder Ionen, etwa H+, HH+, oder Bor implantiert werden. Auch Koimplantation, also die Implantation verschiedener Ionen, kann eingesetzt werden. Die Trennzone 35 verläuft vorzugsweise parallel oder im wesentlichen parallel zu der Oberfläche der Planarisierungsschicht.

Die Implantation erfolgt vorzugsweise durch die Planarisierungsschicht 4 hindurch. Die so hergestellte Planarisierungsschicht kann mit Vorteil besonders eben verlaufen.

Nach dem Ausbilden der Trennzone können Mikrotrennkeime, zum Beispiel durch Vortempern, ausgebildet werden. Für das Vortempern werden vorzugsweise die Zeit so kurz und die Temperatur so niedrig gewählt, dass sich erste Mikrokeime bilden, dass aber noch keine durchgehende oder zumindest partielle Bruchbildung entsteht.

Das Nutzsubstrat wird nachfolgend an einem Substratkörper 2 befestigt. Dieser Substratkörper, der als Sekundärsubstrat dient, kann beispielsweise Saphir, Silizium, SiC, GaAs oder GaN enthalten oder aus einem solchen Material bestehen.

Bevorzugt ist der Substratkörper hinsichtlich der thermischen Ausdehnungskonstante des Materials an diejenige des Muttersubstratmaterials angepasst. Je weniger sich die Ausdehnungskonstanten unterscheiden, desto geringer ist die Gefahr eines Ablösens der Nutzschicht 31 von dem Substratkörper.

Auf den Substratkörper 2 wird eine weitere Bondhilfsschicht 21, etwa eine separate Oxidschicht, aufgebracht.

Die Bondhilfsschicht und/oder gegebenenfalls die weitere Bondhilfsschicht kann ein Oxid, beispielsweise ein Siliziumoxid, wie SiO₂, ein Siliziumoxinitrid, wie SiON, ein TCO-Material wie ITO (Indiumzinnoxid), ZnO, SnO oder SnO₂ enthalten oder aus einem solchen Material bestehen. Alternativ kann die Bondhilfsschicht beispielsweise ein Nitrid, etwa Siliziumnitrid, enthalten oder aus einem solchen Material bestehen.

Das Befestigen des Nutzsubstrats 3 an dem Substratkörper 2 erfolgt bevorzugt mittels Bondens, besonders bevorzugt mittels direkten Bondens.

Auf der dem Nutzsubstrat zugewandten Seite des Substratkörpers 2 ist eine weitere Bondhilfsschicht 21 aufgebracht. Je nach dem verwendeten Substratkörper kann auf diese weitere Bondhilfsschicht kann auch verzichtet werden.

In Figur 1C ist ein Verbundsubstrat 1 gezeigt, bei dem das Nutzsubstrat 3 abgetrennt ist. Das Abtrennen des Muttersubstrats kann beispielsweise durch Ausbilden eines Bruchs, bevorzugt durch Tempern, erfolgen. Auf dem Substratkörper 2 verbleibt eine Nutzschicht 31, auf der beispielsweise eine Halbleiterschichtenfolge epitaktisch abgeschieden werden kann. Der vom Substratkörper abgetrennte Teil des Nutzsubstrats kann für die Herstellung von einem oder mehreren Verbundsubstraten verwendet werden.

Die dem Substratkörper 2 abgewandte Oberfläche der Nutzschicht 31 kann für eine epitaktische Abscheidung perfektioniert werden. Diese Oberflächen-Optimierung kann zum Beispiel durch Anätzen (zum Beispiel GaN-Ätzen mit H₃PO₄ oder KOH) erfolgen.

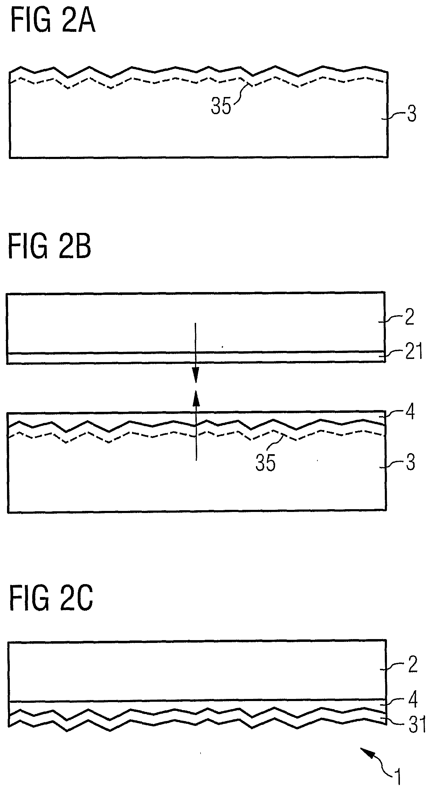

Ein zweites Ausführungsbeispiel für ein erfindungsgemäßes Verfahren ist in den Figuren 2A bis 2C anhand von schematisch in Schnittansicht dargestellten Zwischenschritten dargestellt.

Das zweite Ausführungsbeispiel entspricht im wesentlichen dem im Zusammenhang mit den Figuren 1A bis 1C beschriebenen ersten Ausführungsbeispiel. Im Unterschied dazu wird die Trennzone 35 vor dem Fertigstellen der Planarisierungsschicht 4 in dem Nutzsubstrat 3 ausgebildet. Dies ist in Figur 2A gezeigt.

Vor dem Ausbilden der Trennzone 35 können bereits Schritte zum Glätten des Nutzsubstrats 3 durchgeführt werden, beispielsweise Glätten mittels Schleifens, Läppens, Polierens oder Ätzens.

Gegebenenfalls kann auch eine epitaktisch abgeschiedene Teilschicht der Planarisierungsschicht zum Glätten mittels epitaktischen Überwachsens des Nutzsubstrats vor dem Ausbilden der Trennzone abgeschieden werden. Bei diesem zweiten Ausführungsbeispiel folgt die Trennzone der Oberfläche des Nutzsubstrats, wobei die Glättung dieser Oberfläche noch nicht vollständig abgeschlossen ist.

Wie im Zusammenhang mit dem ersten Ausführungsbeispiel beschrieben, kann die als Abscheidefläche vorgesehene Oberfläche der Nutzschicht 31 nach dem Abtrennen des Nutzsubstrats 3 vom Substratkörper 2 optimiert, beispielsweise eingeebnet, werden.

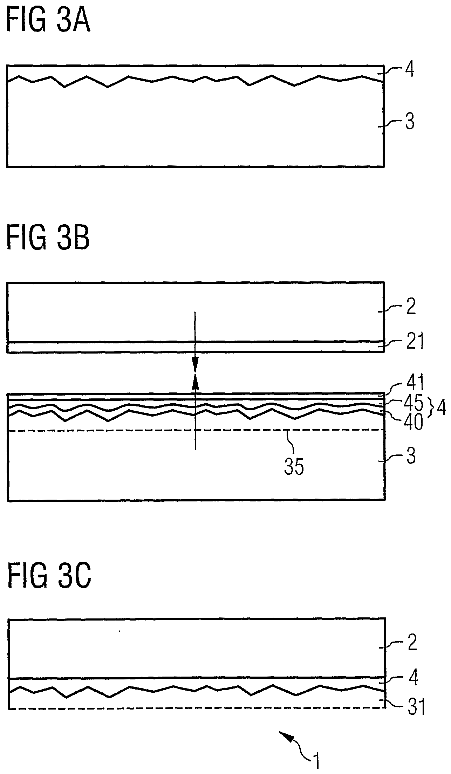

In den Figuren 3A bis 3C ist ein drittes Ausführungsbeispiel für ein erfindungsgemäßes Herstellungsverfahren für ein Verbundsubstrat anhand der schematisch in Schnittansicht dargestellten Zwischenschritte gezeigt. Das dritte Ausführungsbeispiel entspricht im wesentlichen dem ersten Ausführungsbeispiel, wobei der Aufbau der Planarisierungsschicht 4 mit einer ersten Teilschicht 40 und einer zweiten Teilschicht 45 und einer auf der Planarisierungsschicht 4 angeordneten Bondhilfsschicht 41 in Figur 3B dargestellt ist.

Die erste Teilschicht 40 der Planarisierungsschicht 4 ist zwischen dem Nutzsubstrat 3 und der zweiten Teilschicht 45 der Planarisierungsschicht angeordnet. Die erste Teilschicht kann wie im Zusammenhang mit dem ersten Ausführungsbeispiel für die Planarisierungsschicht beschrieben epitaktisch auf dem Nutzsubstrat abgeschieden werden.

Die zweite Teilschicht 45 kann beispielsweise mittels Aufschleuderns, Aufsputterns oder Aufdampfens hergestellt werden. Die zweite Teilschicht 45 der Planarisierungsschicht 4 wird bevorzugt derart ausgebildet, dass sie in einem nachfolgenden Schritt vereinfacht mechanisch und/oder chemisch geglättet werden kann. Weiterhin bevorzugt ist die zweite Teilschicht eine dielektrische Schicht, besonders bevorzugt eine Oxidschicht oder eine Nitrid-haltige Schicht.

Beispielsweise kann die zweite Teilschicht 45 ein Oxid, etwa ein Siliziumoxid, wie SiO₂, ein Siliziumoxinitrid, wie SiON, ein TCO-Material, wie ITO (Indiumzinnoxid), ZnO, SnO oder SnO₂, oder Siliziumnitrid enthalten oder aus einem solchen Material bestehen.

Auf der dem Nutzsubstrat 3 abgewandten Seite der Planarisierungsschicht 4 ist die Bondhilfsschicht 41 aufgebracht. Durch die Bondhilfsschicht 41 wird eine direkte Bondverbindung zwischen dem Nutzsubstrat 3 und dem Substratkörper 2 vereinfacht. Hierbei können die Bondhilfsschicht 41 und die weitere Bondhilfsschicht 21 mittels atomarer Kräfte mechanisch stabil aneinander befestigt werden, wobei die Bondhilfsschicht und die weitere Bondhilfsschicht unmittelbar aneinander angrenzen.

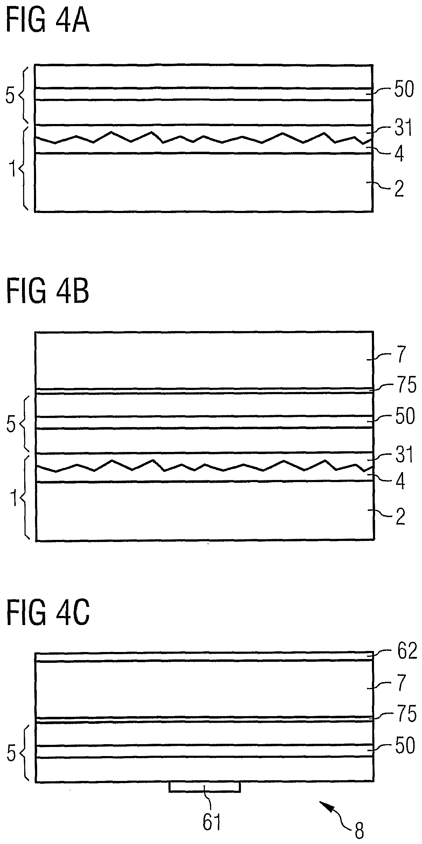

Die Figuren 4A bis 4C zeigen ein Ausführungsbeispiel für ein Herstellungsverfahren für einen Halbleiterchip anhand der schematisch in Schnittansicht dargestellten Zwischenschritte. Das Ausführungsbeispiel zeigt exemplarisch die Herstellung eines Dünnfilm-LED-Halbleiterchips. Das Verfahren ist aber auch zur Herstellung anderer optoelektronischer Halbleiterchips, etwa Strahlungsdetektoren, oder auch zur Herstellung elektronischer Halbleiterchips geeignet.

Zunächst wird ein Verbundsubstrat bereitgestellt, das insbesondere wie im Zusammenhang mit dem ersten, zweiten oder dritten Ausführungsbeispiel beschrieben hergestellt werden kann. Wie in Figur 4A dargestellt, wird auf der Nutzschicht 31 des Verbundsubstrats 1 ein Halbleiterkörper mit einer Halbleiterschichtenfolge 5, vorzugsweise epitaktisch, etwa mittels MOVPE oder MBE, abgeschieden. Die Halbleiterschichtenfolge 5 umfasst einen aktiven Bereich 50, der zur Erzeugung von Strahlung vorgesehen ist. Bevorzugt basiert die Halbleiterschichtenfolge 5, insbesondere der aktive Bereich 50, auf einem Nitrid-Verbindungshalbleiter, besonders bevorzugt mit der Materialzusammensetzung InₓGa_{y}Al_{1-x-y}N mit 0 ≤ x ≤ 1, 0 ≤ y ≤ 1 und x + y ≤ 1. Nitrid-Verbindungshalbeiter sind für die Erzeugung von Strahlung vom ultravioletten über den blauen bis in den grünen Spektralbereich besonders geeignet. Für einen solchen Halbleiterchip basiert die Nutzschicht 31 des Verbundsubstrats 1 vorzugsweise auf GaN.

Auf der dem Verbundsubstrat 1 abgewandten Seite des Halbleiterkörpers 5 wird ein Träger 7 befestigt (siehe Figur 4B). Die Befestigung erfolgt bevorzugt mittels eutektischen Bondens, wobei eine mechanisch stabile Verbindung mittels der Verbindungsschicht 75 hergestellt wird. Die Verbindungsschicht enthält vorzugsweise ein Metall, etwa Au, Ag, Cu, Al, Ni oder Pt, eine metallische Legierung, die zumindest eines der genannten Metalle enthält, oder ein Lot, das beispielsweise Au und/oder Sn enthalten kann. Alternativ kann der Halbleiterkörper auch mittels Klebens an dem Träger befestigt werden. In diesem Fall enthält die Verbindungsschicht zweckmäßigerweise einen, vorzugsweise elektrisch leitfähigen, Kleber.

Der Träger 7 ist also vom Aufwachssubstrat für die Halbleiterschichtenfolge 5 verschieden und muss daher nicht die hohen Anforderungen an ein Aufwachssubstrat, insbesondere hinsichtlich der kristallinen Reinheit, erfüllen. Vielmehr kann der Träger nach anderen Kriterien, etwa elektrischer oder thermischer Leitfähigkeit, oder mechanischer Stabilität gewählt werden. Der Träger kann beispielsweise Ge, Si, Saphir, GaAs, GaN oder SiC enthalten oder aus einem solchen Material bestehen.

Figur 4C zeigt einen fertiggestellten Dünnfilm-LED-Halbleiterchip 8, bei dem das Verbundsubstrat, also das Aufwachssubstrat, vollständig entfernt ist. Das Verbundsubstrat kann beispielsweise mittels eines Lasertrennverfahrens, etwa mittels Laser-Liftoffs, entfernt werden. Davon abweichend kann das Aufwachssubstrat aber auch nur bereichsweise gedünnt oder entfernt sein.

Ein Verbundsubstrat kann sich beispielsweise gegenüber einem GaN-Substrat zum einen durch geringere Kosten und zum anderen durch eine verbesserte Abtrennbarkeit von der Halbleiterschichtenfolge auszeichnen. Im Vergleich zu einem Saphir-Substrat können auf einem Verbundsubstrat Halbleiterschichten mit verbesserter Kristallqualität abgeschieden werden. Ein Verbundsubstrat ist deshalb für die Herstellung eines Dünnfilm-Halbleiterchips besonders geeignet.

Auf der dem Träger 7 abgewandten Seite des Halbleiterkörpers 5 ist ein Kontakt 61 angeordnet. Ein weiterer Kontakt 62 ist auf der dem Halbleiterkörper 5 abgewandten Seite des Trägers angeordnet. Über die Kontakte 61 und 62 kann im Betrieb des Halbleiterchips ein elektrischer Strom in den Halbleiterkörper eingeprägt werden. So in den Halbleiterkörper injizierte Ladungsträger können im aktiven Bereich 50 unter Emission von Strahlung rekombinieren.

Der Kontakt 61 und/oder der Kontakt 62 können beispielsweise mittels Aufdampfens oder Aufsputterns hergestellt werden. Bevorzugt enthalten die Kontakte ein Metall, etwa Au, Ag, Cu, Al, Ni, Ti oder Pt und/oder ein TCO-Material, etwa ITO oder ZnO. Weiterhin können der Kontakt und/oder der weitere Kontakt auch mehrschichtig ausgebildet sein.

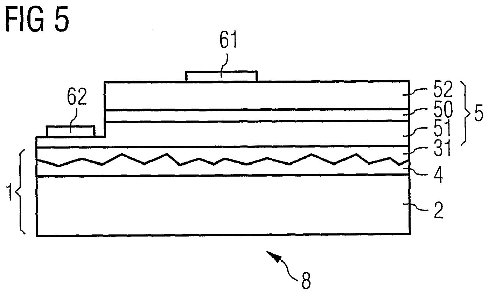

Ein Ausführungsbeispiel für einen Halbleiterchip mit einem erfindungsgemäßen Verbundsubstrat ist in Figur 5 gezeigt.

Das Verbundsubstrat kann insbesondere wie im Zusammenhang mit dem ersten, zweiten oder dritten Ausführungsbeispiel beschrieben hergestellt und ausgeführt sein. Auf der dem Substratkörper 2 abgewandten Seite der Nutzschicht 31 ist ein Halbleiterkörper mit einer Halbleiterschichtenfolge 5 angeordnet.

Der aktive Bereich 50 ist zwischen einer ersten Halbleiterschicht 51 und einer zweiten Halbleiterschicht 52 angeordnet. Die erste Halbleiterschicht befindet sich zwischen dem aktiven Bereich und dem Verbundsubstrat 1.

Auf der dem aktiven Bereich 50 abgewandten Seite der zweiten Halbleiterschicht 52 ist ein erster Kontakt 61 angeordnet.

Die erste Halbleiterschicht 51 ist von der dem Verbundsubstrat 1 abgewandten Seite des Halbleiterkörpers 5 her bereichsweise freigelegt. In dem freigelegten Bereich ist ein weiterer Kontakt 62 angeordnet. Die Kontaktierung des Halbleiterchips 8 erfolgt also von einer Seite des Halbleiterchips. Davon abweichend kann der zweite Kontakt auch auf der dem Halbleiterkörper 5 abgewandten Seite des Substratkörpers 2 angeordnet sein. In diesem Fall ist das Verbundsubstrat 1 zweckmäßigerweise elektrisch leitfähig ausgeführt.

Die Halbleiterschichtenfolge 5 und die Kontakte 61 und 62 können wie im Zusammenhang mit den Figuren 4A bis 4C beschrieben ausgeführt sein. Im Unterschied zu dem im Figur 4C gezeigten Halbleiterchip verbleibt die Halbleiterschichtenfolge auf dem Aufwachssubstrat, also dem Verbundsubstrat 1. Der Substratkörper 2 des Verbundsubstrats ist bevorzugt für im Betrieb des Halbleiterchips im aktiven Bereich 50 erzeugte Strahlung durchlässig, etwa transparent oder transluzent, ausgebildet. Hierfür ist beispielsweise Saphir als Material für den Substratkörper geeignet. Die Strahlung kann somit auch durch den Substratkörper 2 aus dem Halbleiterchip 8 austreten.

Die Erfindung ist nicht durch die Beschreibung anhand der Ausführungsbeispiele beschränkt.

## Patentansprüche

1. Verfahren zur Herstellung eines Verbundsubstrats (1), mit den Schritten:
- Bereitstellen eines Nutzsubstrats (3),
- Aufbringen einer Planarisierungsschicht (4) auf das Nutzsubstrat (3), wobei die Planarisierungsschicht (4) mittels eines Epitaxie-Verfahrens abgeschieden wird, wobei die epitaktische Abscheidung mit Prozessparametern erfolgt, die laterales Wachstum begünstigen, und Glätten der Planarisierungsschicht (4) mechanisch und/oder chemisch, wobei die Planarisierungsschicht (4) zum Einebnen einer Oberfläche des Nutzsubstrats (3) ausgebildet ist und eine von der Nutzschicht (31) abgewandte Oberfläche der Planarisierungsschicht (4) eine Rauhigkeit von höchstens 1 nm aufweist,
- Aufbringen einer Bondhilfsschicht (41) auf die Planarisierungsschicht (4),
- Befestigen des Nutzsubstrats (3), auf dem die Planarisierungsschicht (4) und die Bondhilfsschicht (41) angeordnet sind, auf einem Substratkörper (2) für das Verbundsubstrat (1),
- Abtrennen des Nutzsubstrats (3), wobei eine Nutzschicht (31) des Nutzsubstrats für das Verbundsubstrat (1) auf dem Substratkörper (2) verbleibt.

2. Verfahren nach Anspruch 1,
bei dem eine Trennzone (35) im Nutzsubstrat ausgebildet wird.

3. Verfahren nach Anspruch 2,
bei dem vor der Befestigung des Nutzsubstrats (3) auf dem Substratkörper (2) Mikrotrennkeime entlang der Trennzone (35) ausgebildet werden.

4. Verfahren nach einem der Ansprüche 1 bis 3,
bei dem die Trennzone (35) nach dem Aufbringen der Planarisierungsschicht (4) ausgebildet wird.

5. Verfahren nach einem der Ansprüche 1 bis 4,
bei dem das Nutzsubstrat (3) mittels direkten Bondens auf den Substratkörper gebondet wird.

6. Verfahren zur Herstellung eines optoelektronischen Halbleiterchips (8) mit den Schritten:
- Bereitstellen eines Verbundsubstrats (1) mit einem Substratkörper (2) und einer auf dem Substratkörper angeordneten Nutzschicht (31), das nach einem der Ansprüche 1 bis 5 hergestellt ist,
- Aufwachsen einer Halbleiterschichtenfolge (5) mit einem zur Strahlungserzeugung und/oder zum Strahlungsempfang geeigneten aktiven Bereich (50) für den optoelektronischen Halbleiterchip auf der Nutzschicht (31).

7. Verfahren nach Anspruch 6,
bei dem das Verbundsubstrat (1) gedünnt, bereichsweise entfernt oder vollständig entfernt wird.

## Claims

1. A method of manufacturing a composite substrate (1), comprising the steps of:
- providing a utility substrate (3),
- applying a planarization layer (4) to the utility substrate (3), wherein the planarization layer (4) is deposited by means of an epitaxy process, the epitaxial deposition being carried out with process parameters which favour lateral growth, and smoothing the planarization layer (4) mechanically and/or chemically, wherein the planarization layer (4) is configured to level a surface of the utility substrate (3) and a surface of the planarization layer (4) facing away from the utility layer (31) has a roughness of at most 1 nm,
- applying an auxiliary bonding layer (41) to the planarization layer (4),
- attaching the utility substrate (3), on which the planarization layer (4) and the auxiliary bonding layer (41) are arranged, on a substrate body (2) for the composite substrate (1),
- separating the utility substrate (3), wherein a utility layer (31) of the utility substrate for the composite substrate (1) remains on the substrate body (2).

2. The method according to claim 1,
in which a separation zone (35) is formed in the utility substrate.

3. The method according to claim 2,
in which microseparation nuclei are formed along the separation zone (35) before the utility substrate (3) is attached to the substrate body (2).

4. The method according to any of claims 1 to 3,
in which the separation zone (35) is formed after application of the planarization layer (4).

5. The method according to one of claims 1 to 4,
in which the utility substrate (3) is bonded to the substrate body by direct bonding.

6. A method for producing an optoelectronic semiconductor chip (8) with the steps:
- providing a composite substrate (1) with a substrate body (2) and a utility layer (31) arranged on the substrate body, which is produced according to any of claims 1 to 5,
- growing a semiconductor layer sequence (5) with an active region (50) for the optoelectronic semiconductor chip on the utility layer (31), the active region being suitable for generating and/or receiving radiation.

7. The method according to claim 6,
in which the composite substrate (1) is thinned, removed in areas or completely removed.

## Revendications

1. Procédé en vue de la fabrication d'un substrat composite (1), avec les étapes de :
- mise à disposition d'un substrat utile (3),
- application d'une couche de planarisation (4) sur le substrat utile (3), sachant que la couche de planarisation (4) est précipitée au moyen d'un procédé d'épitaxie, sachant que la précipitation épitaxiale s'effectue avec des paramètres de processus, qui favorisent une croissance latérale et le lissage de la couche de planarisation (4) mécaniquement et/ou chimiquement, sachant que la couche de planarisation (4) est constituée en vue du nivelage d'une surface du substrat utile (3) et qu'une surface de la couche de planarisation (4) détournée de la couche utile (31) présente une rugosité de 1 nm maximum,
- application d'une couche auxiliaire de liaison (41) sur la couche de planarisation (4),
- fixation du substrat utile (3), sur lequel la couche de planarisation (4) et la couche auxiliaire de liaison (41) sont disposées, sur un corps de substrat (2) pour le substrat composite (1),
- séparation du substrat utile (3), sachant qu'une couche utile (31) du substrat utile reste pour le substrat composite (1) sur le corps de substrat (2).

2. Procédé selon la revendication 1,
lors duquel une zone de séparation (35) est constituée dans le substrat utile.

3. Procédé selon la revendication 2,
lors duquel sont constitués avant la fixation du substrat utile (3) sur le corps de substrat (2) des microgermes de séparation le long de la zone de séparation (35).

4. Procédé selon une quelconque des revendications 1 à 3,
lors duquel la zone de séparation (35) est constituée après l'application de la couche de planarisation (4).

5. Procédé selon une quelconque des revendications 1 à 4,
lors duquel le substrat utile (3) est lié au corps du substrat par liaison directe.

6. Procédé en vue de la fabrication d'une puce optoélectronique à semiconducteurs (8), avec les étapes de :
- mise à disposition d'un substrat composite (1) avec un corps de substrat (2) et une couche utile disposée sur le corps de substrat (31), qui est fabriquée selon une quelconque des revendications 1 à 5,
- épitaxie d'une succession de couches à semi-conducteurs (5) avec une zone active (50) convenant en vue de la génération de rayonnement et/ou en vue de la réception de rayonnement pour la puce optoélectronique à semiconducteurs sur la couche utile (31).

7. Procédé selon la revendication 6,
lors duquel le substrat composite (1) est aminci, ôté par zones ou ôté complètement.
